(19) Europäisches Patentamt
European Patent Office
Office européen des brevets

(11) **EP 1 664 934 B1**

(12) **EUROPÄISCHE PATENTSCHRIFT**

(45) Veröffentlichungstag und Bekanntmachung des Hinweises auf die Patenterteilung:
**18.12.2013 Patentblatt 2013/51**

(21) Anmeldenummer: **04786744.5**

(22) Anmeldetag: **10.09.2004**

(51) Int Cl.:
***G03F 7/20*** (2006.01)

(86) Internationale Anmeldenummer:
**PCT/DE2004/002022**

(87) Internationale Veröffentlichungsnummer:
**WO 2005/031465 (07.04.2005 Gazette 2005/14)**

(54) **IMMERSIONS-LITHOGRAPHIE-VERFAHREN UND VORRICHTUNG ZUM BELICHTEN EINES SUBSTRATS**

IMMERSION LITHOGRAPHY METHOD AND DEVICE FOR ILLUMINATING A SUBSTRATE

PROCEDE DE LITHOGRAPHIE PAR IMMERSION ET DISPOSITIF POUR EXPOSER UN SUBSTRAT

(84) Benannte Vertragsstaaten:
**DE FR GB**

(30) Priorität: **25.09.2003 DE 10344567**

(43) Veröffentlichungstag der Anmeldung:
**07.06.2006 Patentblatt 2006/23**

(73) Patentinhaber: **Infineon Technologies AG**
**85579 Neubiberg (DE)**

(72) Erfinder: **NIEHOFF, Martin**
**81379 München (DE)**

(74) Vertreter: **Viering, Jentschura & Partner**
**Am Brauhaus 8**
**01099 Dresden (DE)**

(56) Entgegenhaltungen:
EP-A- 0 605 103   WO-A1-99/49504
WO-A1-2004/107417   US-A- 5 094 536
US-A- 5 879 845   US-B1- 6 191 429
US-B2- 6 586 160

## Beschreibung

Die Erfindung betrifft ein Immersions-Lithographie-Verfahren und eine Vorrichtung zum Belichten eines Substrats.

Bei der Herstellung von hochintegrierten Halbleiterchips werden insbesondere durch die immer weiter steigende Miniaturisierung der Strukturen auf dem Halbleiterchip immer höhere Anforderungen an die für die Herstellung der Halbleiterchips verwendeten Fertigungsanlagen und Herstellungsprozesse auftreten. Ein Problem, welches mit der steigenden Miniaturisierung der hochintegrierten Halbleiterchips auftritt, ist die Limitierung der Miniaturisierung durch das Auflösungsvermögen der verwendeten Lithographietechnik, welche eingesetzt wird, um die Halbleiterchips eines Wafers zu strukturieren.

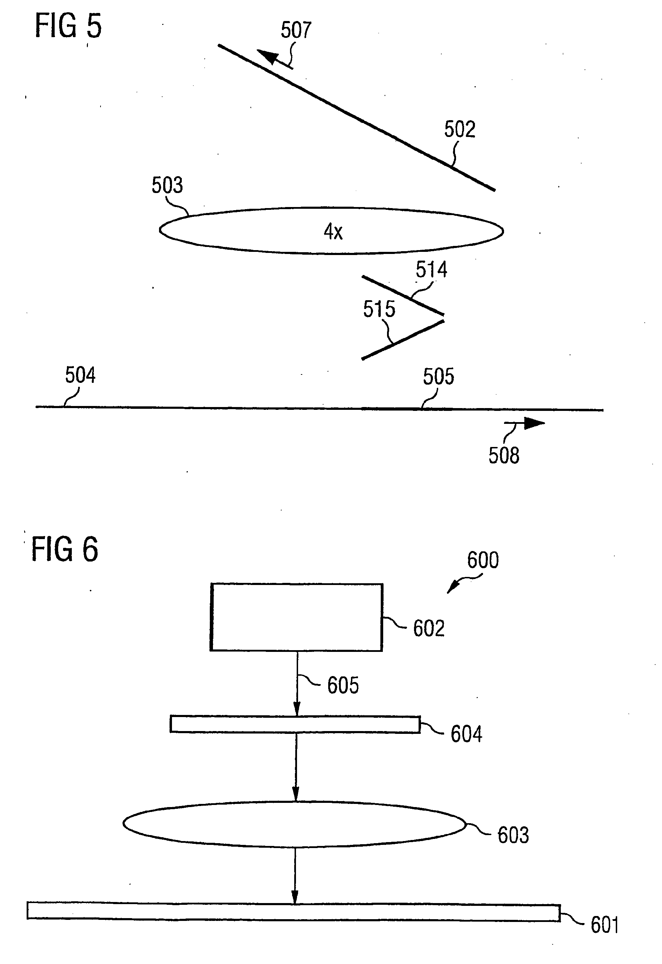

Einleitend ist in Fig. 6 schematisch in vereinfachter Weise eine Lithographievorrichtung 600 dargestellt, welche verwendet werden kann, um einen Wafer 601 zu strukturieren. Die Lithographievorrichtung 600 weist Beleuchtungseinheit 602 und eine Linse 603 auf. Der Wafer 601 wird strukturiert, indem er unter Verwendung einer Maske 604 oder Retikel, belichtet wird. Hierzu wird eine Struktur, welche auf der Maske ausgebildet ist, mittels Laserlichts 605 und der Beleuchtungseinheit durch die Linse 603 auf den Wafer 601 abgebildet, d.h. der Wafer 601 wird belichtet und damit ist eine Strukturierung des Wafers möglich.

Im Stand der Technik sind verschiedene Verfahren zur Durchführung der Lithographie bekannt. Eines ist die Verwendung eines so genannten "Steppers". Bei dem Verwenden eines solchen Steppers wird eine gesamte verwendete Maske auf einmal innerhalb eines einzigen Belichtungsschritts auf ein erstes Belichtungsfeld des Wafer übertragen. Nachfolgend wird der Wafer weiterbewegt und das nächste Belichtungsfeld des Wafers wird belichtet.

Ein anderes Verfahren, welches in der Lithographie Verwendung findet ist eines, welches mittels eines so genannten "Scanners" durchgeführt wird. Bei einem Scanner wird nicht die gesamte Struktur einer Maske in einem Schritt auf ein erstes Belichtungsfeld des Wafer abgebildet, sondern es wird immer nur ein schmaler Streifen der Maske auf einmal auf ein Belichtungsfeld des Wafers abgebildet. Hierzu wird ein so genannter Belichtungsschlitz verwendet, welcher immer nur einen schmalen Streifen der Maske ausleuchtet und durch die Maske bewegt wird. Während der Belichtung eines Belichtungsfeldes bewegt sich das ganze Feld nach und nach durch den Belichtungsschlitz hindurch. Anschaulich wird mittels dieses Belichtungsschlitzes die Maske abgescannt. Während des Abbildens der Maske auf ein Feld des Wafers wird sowohl die Maske als auch der Wafer bewegt. Hierbei findet im Allgemeinen die Bewegung des Wafers und der Maske in die entgegengesetzte Richtung statt. Anschaulich gesprochen wird die Maske mittels des Belichtungsschlitzes abgescannt. Dabei wird jeder Punkt der Maske während des Bewegens durch den Bewegungsschlitz mit mehreren Laserblitzen (pulsen) auf den Wafer belichtet.

Die Auflösung einer Lithographietechnik ist gegeben durch die Gleichung (1):

$$R = k_1 \cdot \frac{\lambda}{n \cdot \sin(\theta)}$$

wobei:

R die Auflösung ist,
$k_1$ ein vom Prozess abhängiger Faktor ist,
$\lambda$ die Vakuum-Wellenlänge des für die Lithographie verwendeten Strahls ist, und
$n \cdot \sin(\theta)$ die so genannte numerische Apertur ist, mit n als Brechungsindex des Mediums, in welchem die Lithographie durchgeführt wird, und $\theta$ als Öffnungswinkel der Linse.

Der prozessabhängige Faktor $k_1$ weist aus physikalischen Gründen einen Wert von größer als 0,25 auf. Anschaulich ist $k_1$ größer als 0,25, um sicherzustellen, dass ein gleichmäßiges Muster aus Linien und Zwischenräumen, d.h. ein Wechsel aus Hell und Dunkel, abgebildet werden kann und als solches Muster noch zu erkennen ist. In der Lithographie ist die Wellenlänge zur Zeit noch auf Wellenlängen von mehr als ungefähr 150 nm begrenzt, da bisher keine Materialien bekannt sind, welche für Licht kürzerer Wellenlänge transparent sind.

Aus diesen Randbedingungen ergibt sich, dass zur Erhöhung des Auflösungsvermögens, welche Erhöhung für eine Lithographie für die Strukturierung kleiner Strukturen nötig ist, kaum eine Änderung an $k_1$ oder an $\lambda$ vorgenommen werden kann. Als einziger Faktor verbleibt somit $n \cdot \sin(\theta)$, die so genannte numerische Apertur der Vorrichtung, welche auch als NA bezeichnet wird. Hierbei ist zu beachten, dass aus mathematischen Gründen $\sin(\theta) \leq 1$ gilt. Anschaulich gibt $\theta$ den Öffnungswinkel an, unter dem Licht in ein abbildendes Element (Linse) eintreten kann, damit es das abbildende Element auch wieder verlässt, ohne totalreflektiert zu werden, und ist daher ein Mass für die in das abbildende Element eintretende Lichtstärke und das Auflösungsvermögen der Lithographievorrichtung.

Üblicherweise wurden lithographische Verfahren in der Halbleiterherstellung mittels Luft als Immersionsmedium durchgeführt, d.h. als Medium, welches sich zwischen abbildendem Element und Substrat befindet. Somit ergibt sich ein Brechungsindex von n ≈ 1. Wird nun das lithographische Verfahren mit einem anderen Medium als Luft durchgeführt, d.h. eine so genannte Immersions-Lithographie, durchgeführt, so kann das Auflösungsvermögen um einen Faktor verbessert werden, welcher gleich dem Brechungsindex des Immersionsmediums ist. Bei einem solchen Immersions-Verfahren wird in einen Zwischenraum zwischen einem abbildenden Element, d.h. z.B. einer Linse, und einer Lithographievorrichtung eine Flüssigkeit eingeführt, welche einen Brechungsindex von n > 1 hat.

Durch das Verwenden eines Immersionsmediums ist es möglich zu erreichen, dass zusätzliches Licht zu der Lichtstärke des abbildenden Elements beiträgt. Licht, welches unter einem Winkel in das abbildende Element einfällt, welcher zu groß ist, um bei einem Immersionsmedium von Luft noch zu der Lichtstärke des abbildenden Elements beizutragen, d.h. total reflektiert würde, kann bei dem Verwenden eines Immersionsmediums mit einer höheren Brechzahl als n = 1 noch zu der Lichtstärke beitragen. Hierdurch ist das Erzielen einer besseren Auflösung möglich, oder die Schärfentiefe der Abbildung kann bei gleicher Auflösung vergrößert werden.

Ein Nachteil der Immersionslithographie ist jedoch, dass das Immersionsmedium einen Teil des Lichts absorbiert, welches für die Belichtung des Wafers verwendet wird. Durch die Absorption wird das Immersionsmedium aufgeheizt. Das Aufheizen des Immersionsmediums wiederum führt zu einer Änderung des Brechungsindexes des Immersionsmediums. Für Wasser gibt es für die Änderung des Brechungsindex mit der Temperatur T Abschätzungen, welche für eine Wellenlänge von $\lambda$ =193 nm etwa $dn/dT=10^{-4}K^{-1}$ betragen.

Dies wiederum führt zu einer leichten Änderung des Abstandes zwischen abbildenden Elements und Wafer, in welchem Abstand die beste Fokussierung erzielt werden kann, d.h. die Abbildung am schärfsten ist oder anders ausgedrückt die Auflösung den kleinsten Wert aufnimmt. Die Änderung der Temperatur und damit des Brechungsindex des Flüssigkeit führt auch zu einer Verringerung der Schärfentiefe, der so genannten "Depth of Focus" (DoF) der Abbildung. Bei einem Lithographieverfahren wird hierdurch die Schärfentiefe des projizierten Bildes, d.h. das Bild der Maske, verringert, wodurch ein Prozessierungsfenster für das Lithographieverfahren, d.h. welche Schwankungsbreite, die Parameter der Lithographie aufweisen dürfen, verringert wird.

Ein Ansatz, dieses Problem zu lösen, liegt in der Kontrolle der Temperatur der Immersionsflüssigkeit. D.h. es wird versucht die Temperatur möglichst konstant zu halten und innerhalb eines kleinen Temperaturintervalls zu stabilisieren. Dies muss jedoch sehr exakt erfolgen. Eine solch exakte Temperaturkontrolle ist kostspielig und nur schwer zu erreichen. Verbleibende Fokusänderungen haben weiterhin einen negativen Einfluss auf die Schärfentiefe der Abbildung und auf die Auflösung des Lithographie-Verfahrens.

Um etwa die Größenordnung anzugeben, wie exakt die Temperatur einzuhalten ist und wie groß der Einfluss einer verbleibenden Temperaturänderung ist, wird dieses anhand eines.Beispieles abgeschätzt. Für eine Wellenlänge von $\lambda$ = 193 nm, einen Brechungsindex von n = 1,47 (Deionisiertes Wasser), einen sin($\theta$) = 0,75 und einen Arbeitsabstand, d.h. einen Abstand zwischen abbildenden Element und zu strukturierender Waferoberfläche, von D = 1 mm muss $\delta_n$ <6·10⁻⁷ eingehalten werden, wenn eine Änderung des Abstandes der scharfen Abbildung von $\Delta D$ < 1 nm eingehalten werden soll, wobei $\delta n$ die Änderung des Brechungsindex ist. Aus dem $\delta n$ <6·10⁻⁷ und der oben schon angesprochenen Abschätzung von $dn/dT=10^{-4}K^{-1}$ lässt sich anhand von Gleichung (2)

$$\Delta D = \frac{D \cdot \delta n}{n \cdot \cos^2 \theta}$$

berechnen, wie exakt die Temperatur kontrolliert und geregelt werden muss. Es ergibt sich eine notwendige Genauigkeit von 6 mK. Diese Genauigkeit der Temperaturkontrolle ist nur schwer einzuhalten, wodurch die Verwendung von Immersionslithographie bei der Strukturierung von Halbleiterelementen stark behindert und erschwert ist.

Aus [1] ist eine Fokussiervorrichtung bekannt, welche ein Objektiv-System zum optischen Herstellen eines Werkstückes, zum Ausbilden eines gewünschten Musters auf einer Oberfläche eine Werkstückes oder zum Inspizieren eines Musters auf einem Werkstück aufweist und welches verwendet wird, den Fokuszustand zwischen der Oberfläche des Werkstückes und den Objektiv-System einzustellen.

Aus [2] ist ein Scan-Belichtungssystem für die Trockenlithographie bekannt, wobei das System derart eingerichtet ist, dass ein Retikel und eine zu belichtende Oberfläche eines Substrats beim Belichten gegeneinander verkippt sind. Bei einem gewölbten oder nicht-planaren Substrat lässt sich die Oberfläche dadurch auch präzise Belichten.

Aus US 5 094 536 A ist ein Substrat-Träger für lithographische Anwendungen bekannt, womit eine gewölbte oder nicht-planare Oberfläche eines Substrats gezielt planiert werden kann.

WO 2004/107417 A, die nachveröffentlichten Stand der Technik gemäß Art. 54(3) EPÜ darstellt, offenbart eine Immersions-Lithographie-Vorrichtung, wobei das Substrat während des Belichtens verkippt wird. Dadurch können Schärfentiefeänderungen kompensiert werden, welche dadurch entstehen, dass sich die Immersionsflüssigkeit aufgrund einer Belichtung mittels einer inhomogen strukturierten Maske in unterschiedlichen Bereichen unterschiedlich stark erwärmt.

WO 99/49504 A offenbart eine Immersions-Lithographie-Vorrichtung.

Aus [3] ist eine Immersionslithographievorrichtung bekannt, wobei ein Arbeitsabstand zwischen der Vorrichtung und einem Werkstück einer Relation genügt, welche den Temperaturkoeffezienten des Brechungsindex des Immerionsfluid und die Temperatur berücksichtigt.

Aus [4] ist bekannt, dass Linienbreiten-Steuerparameter innerhalb eines Musters als Folge von Eigenschaften einer Lithographievorrichtung variieren und dass diese Variationen mittels Linienbreite-Offset-Koeffizienten kompensiert werden können.

Der Erfindung liegt das Problem zugrunde, die oben genannten Nachteile des Standes der Technik zu lösen und ein Immersions-Lithographie-Verfahren zum Belichten eines Substrats und eine Vorrichtung für ein solches Verfahren zu schaffen, welche das Problem der genauen Temperaturkontrolle bei der Immersions-Lithographie reduzieren.

Das Problem wird durch ein Immersions-Lithographie-Verfahren zum Belichten eines Substrats und einer Vorrichtung zum Durchführen eines solchen Verfahrens mit den Merkmalen gemäß den unabhängigen Patentansprüchen gelöst.

Ein Immersions-Lithographie-Verfahren zum Belichten eines Substrats wird mit einer Scan-Belichtungsvorrichtung durchgeführt, die eine Strahlquelle, welche einen Strahl erzeugt, einen Halter, welcher ein Retikel aufnimmt, einen Träger, auf welchem ein Substrat angeordnet ist, und ein abbildendes Element aufweist, welches zwischen dem Retikel und dem Substrat angeordnet ist, wobei beim Belichten des Substrats ein Immersionsfluid zwischen das abbildende Element und das Substrat eingebracht ist und wobei beim Verfahren der Strahl von der Strahlungsquelle durch das Retikel, durch das abbildende Element und durch das Immersionsfluid hindurch auf eine zu belichtende Oberfläche des Substrat läuft, der Strahl das Retikel in einer erste Richtung abscannt, der Träger beim Belichten des Substrats in eine zweite Richtung bewegt wird und die Schärfentiefe und/oder Auflösung des Belichtens, oder anders ausgerückt die Position des besten Fokus beim Belichten, der Oberfläche des Substrats eingestellt wird, indem beim Belichten mit dem Retikel ein Abstand in Strahlrichtung zwischen dem Retikel und der Oberfläche des Substrats entlang der Bewegungsrichtung des Trägers variiert wird.

Eine Vorrichtung zum Durchführen einer Immersions-Lithograpie zum Belichten eines Substrats, weist eine Strahlquelle zum Emittieren eines Strahls, einen Träger, auf welchem ein Substrat angeordnet werden kann, einen Halter zum Aufnehmen eines Retikels und ein abbildendes Element auf, welches zwischen dem Halter und dem Träger angeordnet ist. Bei der Vorrichtung sind der Träger und der Halter derart eingerichtet, dass sie gegeneinander bewegbar sind, und die Anordnung ist derart eingerichtet, dass ein Immersionsfluid zwischen das abbildende Element und den Träger einbringbar ist. Ferner ist die Anordnung derart eingerichtet, dass ein im Halter angeordnetes Retikel und eine zu belichtende Oberfläche eines auf dem Träger angeordneten Substrats beim Belichten der Oberfläche des Substrats gegeneinander verkippt sind.

Anschaulich kann die Erfindung darin gesehen werden, dass eine Verringerung der Schärfentiefe und/ oder eine Vergrößerung der Auflösung, welche durch die Erwärmung einer Immersionsflüssigkeit, welche Erwärmung durch einen Strahl, z.B. Laserstrahl, hervorgerufen wird und zu einer Verschiebung der besten Fokusposition führt, nicht allein durch eine Kontrolle der Temperatur der Immersionsflüssigkeit verhindert wird, sondern mittels einer verkippten Anordnung des Retikel und des Trägers, auf welchem ein zu strukturierendes Substrat angeordnet ist, d.h. ein Substrat, welches eine zu belichtende Oberfläche aufweist. Anschaulich nimmt der Abstand zwischen dem Retikel und der zu belichtenden Oberfläche des Substrat in der Bewegungsrichtung des Trägers zu oder ab. Anders ausgedrückt sind das Retikel im Halter und die zu belichtende Oberfläche des Substrats nicht parallel zueinander ausgerichtet, sondern weisen einen Relativwinkel zueinander aus. Die Anordnung ist so ausgestaltet, dass es mit ihr möglich ist mittels des unterschiedlichen Abstandes, zwischen Retikel und der zu belichtenden Oberfläche des Substrats, der aus diesem Relativwinkel resultiert, die Änderung der Position des besten Fokus auszugleichen. D.h., dass das $\Delta D$ aus Gleichung (2), welches sich für einen gegebenen Temperaturanstieg ergibt, nicht durch Kontrolle der Temperatur verhindert wird, sondern mittels eines zusätzlichen $\Delta D$, welches sich durch den Relativwinkel zwischen Retikel und der zu belichtenden Oberfläche des Substrats ergibt, kompensiert wird.

Anders ausgedrückt, sind der Normalenvektor der zu belichtenden Oberfläche des Substrats, welcher in guter Näherung eine plane Fläche darstellt, und der Normalenvektor des Retikels, welches in guter Näherung eine plane Fläche darstellt, nicht parallel oder antiparallel ausgerichtet, sondern weisen den Relativwinkel auf. Unter der Position des besten Fokus kann die Position verstanden werden, in der die Schärfentiefe und/oder Auflösung in der Position am besten ist, d.h. die Schärfentiefe am größten und/oder die Auflösung am kleinsten.

Die erfindungsgemäße Anordnung und das erfindungsgemäße Verfahren haben den Vorteil, dass es mit ihnen wesentlich einfacher ist, die negativen Einflüsse der Erwärmung des Immersionsfluid auf die Schärfentiefe und/oder Auflösung zu verhindern. Der Relativwinkel und damit der Abstand zwischen Retikel und der zu belichtenden Oberfläche des Substrats lässt sich wesentlich leichter messen und regeln als eine Temperatur, welche, wie oben beschrieben, auf wenige mK genau zu regeln ist.

Das Einstellen der Schärfentiefe und/oder der Auflösung ist insbesondere ein Konstanthalten der Schärfentiefe und/oder Auflösung während des Belichten eines einzelnen auf dem Substrat zu strukturierenden elektronischen Bauelements.

Bevorzugte Weiterbildungen der Erfindung ergeben sich aus den abhängigen Ansprüchen. Hierbei gelten bevorzugte Weiterbildungen des Immersions-Lithographie-Verfahrens zum Belichten eines Substrats auch für die Vorrichtung, und umgekehrt.

Vorzugsweise erfolgt die Variation des Abstandes derart, dass die während des Belichtens durch eine Temperaturänderung des Immersionsfluid während des Belichtens verursachte Schärfentiefe- und/oder Auflösungsänderung kompensiert wird.

In einer Weiterbildung ist das Immersionsfluid ein Fluid, welches eine hohe Transparenz bei einer gegebenen Belichtungswellenlänge und/oder ein kleines dn/dT aufweist.

Eine hohe Transparenz des Immersionsfluid, z.B. einer Flüssigkeit, bei der bei dem Verfahren verwendeten Belichtungswellenlänge führt zu einer geringen Absorption bei der Belichtung, damit zu einen geringeren Energieeintrag in das Immersionsfluid und damit auch zu einer geringeren Erwärmung. Ein kleines dn/dT wiederum führt zu einer nur geringen Änderung des Brechungsindex bei einer gegebenen Temperaturänderung und damit zu einer nur geringen Änderung der Position des besten Fokus. Vorzugsweise beträgt die Transparenz mehr als 0,9 besonders bevorzugt mehr als 0,95. Vorzugsweise beträgt das dn/dT weniger als $10^{-3}$ besonders bevorzugt weniger als etwa $10^{-4}$.

Das Immersionsfluid kann Wasser oder ein Perfluorpolyether sein.

Wasser und Perfluorpolyether weisen einen hohen Brechungsindex bei gleichzeitig guten Transmissionseigenschaften, d.h. gute Strahldurchlässigkeit, auf. Somit lassen sich die Totalreflektion beim Austritt des Strahls aus dem abbildenden Element effektiv verhindern und die numerische Apertur erhöhen. Dies wiederum führt zu einer verbesserten Auflösung oder zu einer verbesserten Schärfentiefe bei gleicher Auflösung. Vorzugsweise wird als Wasser hochreines deionisiertes Wasser verwendet, weil sowohl in dem Wasser gelöste Gase, wie zum Beispiel Sauerstoff, als auch gelöste Feststoffe, wie zum Beispiel Fremdatome, die optischen Eigenschaften des Wasser beeinflussen. Insbesondere kann Wasser als Immersionsmedium bei einer für die Lithographie verwendeten Wellenlänge von 193 nm verwendet werden und Perfluorpolyether, wie zum Beispiel das unter dem Handelsnamen Krytox® bekannte, für die Lithographie mit.einer Wellenlänge von 157 nm verwendet werden.

Vorzugsweise wird der Träger im Bezug auf das Retikel schräg bewegt. D.h. der Träger wird nicht parallel zu einer Hauptrichtung des Retikel, welches in guter Näherung eine plane Fläche darstellt, bewegt, sondern er wird schräg, d.h. mit einem Relativwinkel zu der Hauptrichtung des Retikel bewegt. Durch die Schrägbewegung des Trägers lässt sich auf einfache Weise erreichen, dass der Abstand zwischen dem Retikel und der zu belichtenden Oberfläche des Substrats, welches auf den Träger angeordnet ist, entlang der Bewegungsrichtung variiert. Hierdurch lässt sich ein ΔD, welches sich durch die Änderung des Brechungsindex des Immersionsfluid durch den Temperaturanstieg während des abscannen des Retikels verursacht wird, auf leichte Weise kompensieren und die Auflösung der Belichtung verbessern und/ oder die Schärfentiefe der Belichtung vergrößern.

Besonders bevorzugt ist das Retikel gegenüber der zu belichtenden Oberfläche des Substrats verkippt.

Auch durch das Kippen des Retikels gegenüber dem Substrat lässt sich auf einfache Weise erreichen, dass der Abstand zwischen dem Retikel und der zu belichtenden Oberfläche des Substrats, welches auf den Träger angeordnet ist, entlang der Bewegungsrichtung variiert. Hierdurch lässt sich wiederum ein ΔD, welches durch die Änderung des Brechungsindex des Immersionsfluid durch den Temperaturanstieg während des abscannen des Retikels verursacht wird, auf leichte Weise kompensieren und die Auflösung der Belichtung verbessern und/oder die Schärfentiefe der Belichtung vergrößern.

Das Verkippen des Retikels ist besonders vorteilhaft, da üblicherweise bei einer Scan-Belichtungsvorrichtung ein verkleinerndes abbildendes Element verwendet wird. Hierdurch kann auf dem Retikel die Struktur, welche verwendet wird, um das Substrat zu belichten, vergrößert dargestellt werden. Angenommen die Struktur auf den Retikel besitzt in der X-Y-Ebene des Retikels eine Ausdehnung von 100 nm x 100 nm, so wird sie bei einem abbildenden Element, welches 4:1 verkleinert auf eine Fläche in der X-Y Ebene von 25 nm x 25 nm abgebildet. Das abbildende Element wirkt sich jedoch nicht nur in der X-Y Ebene aus sondern auch in der Z-Richtung und zwar in der Weise, dass eine Änderung der z-Position des Retikel um 16 mm eine Verschiebung des Fokus, d.h. der X-Y-Ebene des schärfsten Abbildes nach dem abbildenden Element, um nur 1 mm bewirkt. Dies entspricht einer "Untersetzung" der Verschiebung der z-Position. Dadurch lässt sich auf einfache Weise der Abstand zwischen dem Retikel und dem Substrat regeln, da etwaige Ungenauigkeiten in der Regelung der Verkippung des Retikels um einen Faktor 16 reduziert werden.

In einer Weiterbildung verläuft die Variation des Abstand zwischen Retikel und der zu belichtenden Oberfläche des Substrats entlang der Bewegungsrichtung des Trägers linear.

Anschaulich betrachtet, bedeutet dies, dass mit zunehmender Bewegung des Substrats innerhalb eines Belichtungsfeldes, d.h. eines Feldes auf dem Substrat, welches mittels eines Retikels belichtet wird und welches nach beenden des Prozessierens ein einzelnes elektronisches Bauteil darstellt, die Variation des Abstandes zwischen der zu belichtenden Oberfläche des Substrats einen linearen Anteil hat, d.h. der Abstand wird linear größer oder kleiner. Eine lineare Abnahme des Abstandes ist vorteilhaft, da sie sich leicht erzielen lässt. Andererseits ist sowohl die Änderung des Brechungsindex in Abhängigkeit mit der Änderung der Temperatur als auch die Änderung der z-Position des Fokus in Abhängigkeit mit der Änderung des Brechungsindexes in erster Näherung linear. D.h. dn/dT ≈ konstant und dz/dn ≈ konstant. Hieraus ergibt sich, dass bei einer Belichtungsvorrichtung, welche kein Stepper ist, sondern eine scannende Arbeitsweise aufweist, Δz, d.h. die Änderung der Fokusposition in z-Richtung, proportional, zu der Belichtungsenergie, die ein zu belichtender Punkt schon erfahren hat, und damit auch proportional zu der Position innerhalb eines Beleuchtungsschlitzes ist, mit dessen Hilfe das Retikel abgescannt wird, was wiederum dazu führt, dass es zum Kompensieren der Fokusänderung vorteilhaft ist, den Abstand zwischen Retikel und der zu belichtenden Oberfläche des Substrats linear zu verändern.

Die zweite Richtung kann der ersten Richtung entgegengesetzt sein.

Vorzugsweise wird die Temperatur des Immersionsfluid geregelt.

Bei einer zusätzlichen Temperaturregelung des Immersionsfluid kann die Temperaturregelung dazu verwendet werden, eine Grobsteuerung der Schärfentiefe und/oder der Auflösung des Belichtens durchzuführen, während die Feinsteuerung der Schärfentiefe und/oder der Auflösung des Belichtens mittels des Variierens des Abstandes zwischen Retikel und der zu belichtenden Oberfläche des Substrats durchgeführt wird. D.h. etwaige durch ungenaue Temperaturregelung auftretende Änderungen des Fokus, können mittels der Abstandsvariation kompensiert werden.

Das abbildende Element kann eine Linse oder ein Linsensystem sein.

In einer Weiterbildung wird das Immersionsfluid während dem Belichten zwischen das abbildende Element und das Substrat eingebracht.

Anschaulich heißt das, dass das Immersionsfluid während des Belichtens eines Substrats zum Beispiel in den Zwischenraum zwischen abbildenden Element und Substrat eingespritzt wird. Das Einspritzen stellt ein einfach durchzuführendes Verfahren dar, um das Immersionsfluid bereitzustellen.

In einer Weiterbildung werden vor der Belichtung des Substrats in einem Kalibrierungsschritt für das Substrat die Abstandsvariationen als Offsets bestimmt und es werden bei der Belichtung des Substrats die ermittelten und gespeicherten Offsets verwendet, um die Abstandsvariationen durchzuführen, d.h. einzustellen.

Im Allgemeinen wird vor der Belichtung innerhalb einer Lithographie das Substrat kalibriert, um es später für die Belichtung korrekt auszurichten. Hierbei werden Kalibrierungswerte erhalten. Auf diese Kalibrierungswerte können dann die Offsets, welche sich für die Kompensation für die Variationen des besten Fokusposition durch die Temperaturänderung des Immersionsfluid ergeben, hinzuaddiert werden. Diese Offsets können bestimmt werden, indem sie beispielsweise ausgerechnet werden, oder auch in der Kalibrationsmessung gemessen werden. Die Berechnung wird nachfolgend näher erläutert.

Die Kalibration, das Bestimmen und Hinzuaddieren der Offsets können auch im so genannten "On-Fly" Verfahren durchgeführt werden. Hierzu kann für die Kalibration eine CCD-Kamera verwendet werden, welche im Allgemeinen in einer Lithographievorrichtung vorhanden ist. "On-Fly" bedeutet hierbei, dass die Kalibration unmittelbar vor einem sich direkt anschließenden Belichtungsschritt durchgeführt wird, d.h. innerhalb eines Verfahrens, welches keiner zeitlichen Unterbrechung unterliegt.

Zusammenfassend kann die Erfindung darin gesehen werden, dass bei einer Immersion-Lithographie-Technik nicht versucht wird, die Auswirkungen einer Temperaturänderung des Immersionsmediums primär durch Regelung der Temperatur zu verhindern, sondern mittels Variierens des Abstandes zwischen einem verwendeten Retikel und einer zu belichtenden Oberfläche eines Substrats zu kompensieren, d.h. auszugleichen. Anschaulich gesprochen wird ein Relativwinkel zwischen dem verwendeten Retikel und dem zu belichtenden Substrat eingestellt, welcher so groß ist, dass mittels dieses Relativwinkels sich der Abstand zwischen Retikel und der zu belichtenden Oberfläche des Substrats während der Belichtung des Substrates ändert, und zwar in dem Maß, wie es nötig ist, um die Änderung der z-Position des besten Fokus, welche Änderung durch die Temperaturänderung des Immersionsmediums verursacht wird, zu kompensieren.

Der Relativwinkel muss vor der Belichtung berechnet werden, um ihn während der Belichtung berücksichtigen zu können. Um ihn zu berechnen ist es nötig die Energiedosis, welche das Immersionsmedium, während der Belichtung aufnimmt, zu bestimmen, um daraus die Änderung der z-Position des besten Fokus zu bestimmen. Dies kann während eines ohnehin schon üblichen Kalibrierungsschrittes durchgeführt werden, welcher für jedes Belichtungsfeld eines Substrats oder je Substrat einmal oder in vorgegebenen zeitlichen Abständen durchgeführt wird. Anschaulich wird jedes Belichtungsfeld eines Substrats vor der eigentlichen Belichtung mittels einer Kalibrierungsvorrichtung abgescannt, um die für die Belichtung benötigten Informationen zu erhalten. Hierbei wird unter anderen ein Höhenprofil der zu belichtenden Oberfläche des Substrats erstellt, um eine exakte Lithographie durchzuführen. Zu diesem Höhenprofil, wird dann noch ein Offset hinzuaddiert, welcher dem linear zunehmenden Offset entspricht, welcher durch die Temperaturerhöhung des Immersionsmediums verursacht wird. Zu beachten ist, dass der Offset nicht für jedes Feld zu messen ist sonder es im allgemeinen ausreicht, wenn der Offset in vorgegeben zeitlichen Abständen gemessen wird. Ein Kriterium für die zeitlichen Abstände ist zum Beispiel, dass sichergestellt wird, dass zwischen zwei Messungen sich keine Veränderungen ergeben haben, welche sich auf die Position des besten Fokus auswirken.

Die Auswirkungen der Temperaturänderung des Immersionsmediums liegen primär darin, dass sich der Brechungsindex des Immersionsmediums ändert. Hieraus folgt, dass sich die z-Position, d.h. der Abstand in dem hinter einem abbildenden Element ein scharfes Abbild entsteht, mit der Temperatur des Immersionsmediums ändert. Die Änderung der z-Position des Fokus wiederum führt, falls sie nicht kompensiert wird zu einer Auflösungsverschlechterung und oder einer geringeren Schärfentiefe bei der Belichtung des Substrats. Die Änderung der z-Position ist näherungsweise linear über den Belichtungsschlitz und kann daher durch Verkippen von Retikel und/oder Substrat ausgeglichen werden.

Ausführungsbeispiele der Erfindung sind in den Figuren dargestellt und werden im Weiteren näher erläutert.

Es zeigen:

Figur 1     eine schematische Darstellung einer Scan-Belichtungsvorrichtung gemäß einem Ausführungsbeispiel der Erfindung,

Figur 2     eine schematische Darstellung, in welcher das Einbringen eines Immersionsfluid dargestellt ist,

Figur 3     eine schematische Darstellung, der Temperatur eines Immersionsfluid während einer Belichtung und der Position des Fokus in Relation zu der Position innerhalb des Belichtungsschlitzes,

Figur 4     eine schematische Seitenansicht einer Scan-Belichtungsvorrichtung gemäß einem ersten Ausführungsbeispiel der Erfindung,

Figur 5     eine schematische Seitenansicht einer Scan-Belichtungsvorrichtung gemäß einem zweiten Ausführungsbeispiel der Erfindung,

Figur 6     eine schematische vereinfachte Darstellung einer Lithographievorrichtung gemäß dem Stand der Technik.

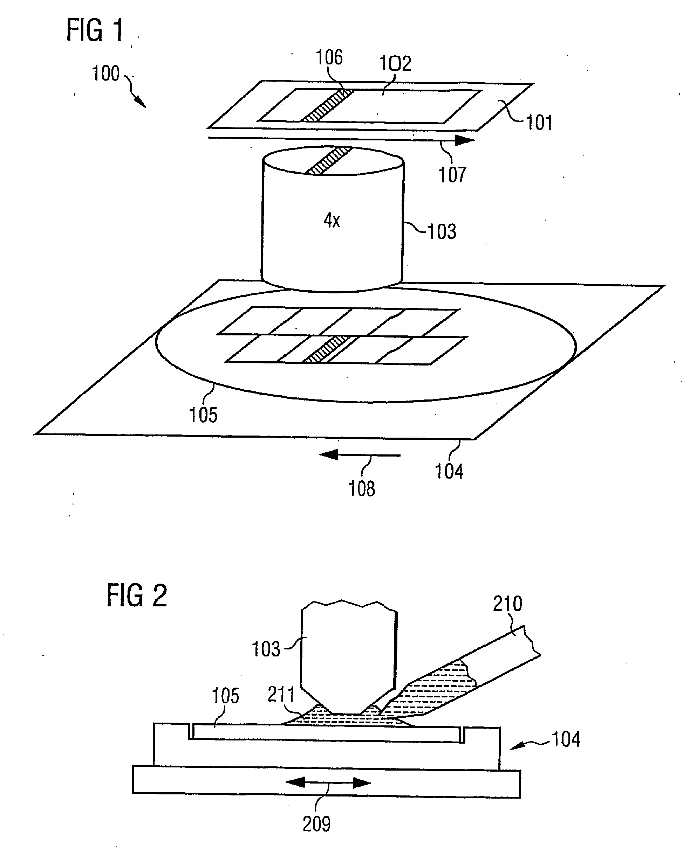

**Fig. 1** zeigt eine schematische Abbildung einer Scan-Belichtungsvorrichtung 100 für eine Immersions-Lithographie. Die Scan-Beleuchtungsvorrichtung wird auch "Scanner Exposure Tool" oder kurz Scanner genannt. Zum Zwecke einer verbesserten Übersichtlichkeit ist in Fig. 1 kein Immersionsfluid dargestellt.

Ein Scanner 100 weist einen Halter 101, welcher ein Retikel 102 aufnimmt, ein abbildendes Element 103, z.B. eine Linse oder ein Linsensystem, und einen Träger 104 auf, auf welchem ein Substrat 105 angeordnet ist. Das Retikel 102 wird in Fig. 1 von oben von einer Strahlquelle (nicht dargestellt), z.B. einem Laser, beleuchtet. Der Strahl der Strahlquelle durchtritt das Retikel 102 und verläuft in der Fig. 1 weiter nach unten in Richtung des Substrats. Mittels eines so genannten Belichtungsschlitzes 106 wird erreicht, dass nur ein kleiner Bereich des Retikels 102 belichtet wird, d.h. nur ein kleiner Teilbereich des Retikel 102 wird ausgeleuchtet und die betreffenden Strahlen können in das Linsensystem 103 gelangen. Der Belichtungsschlitz 106 ist in Fig. 1 als schraffierter Bereich innerhalb des Retikels 102 angedeutet. Ferner ist, um kenntlich zu machen, dass nur Strahlen eines kleinen Teilbereichs in das Linsensystem 103 gelangen, dieser Teilbereich in der Fig. 1 auf der Oberseite des Linsensystems 103 hell dargestellt. Das Linsensystem 103 ist derart ausgebildet, dass es ein scharfes Abbild von Strukturen, welche auf den Retikel 102 vorhanden sind, auf dem Substrat 105 erzeugt. Der Bereich des Substrats 105, welcher gerade belichtet wird, ist in Fig. 1 wiederum als heller Streifen dargestellt. Im Allgemeinen wird der Strahl gepulst abgegeben, so dass einen große Anzahl von kurzen Strahlpulsen verwendet wird, um das Substrat 105 zu belichten.

Um alle Strukturen des Retikel 102 auf dem Substrat 105 abzubilden, bewegt sich das Retikel 102 gegenüber dem Belichtungsschlitz 106. In der Fig. 1 ist diese Bewegung und die Richtung derselben mit einem ersten Pfeil 107 nach rechts angedeutet. Durch die Bewegung des Retikel 102 gegenüber dem stationären Belichtungsschlitz 106 wird das gesamte Retikel von dem Strahl der Strahlquelle abgescannt und auf dem Substrat 105 abgebildet. Um eine scharfe Abbildung auf dem Substrat 105 zu erlangen, muss jedoch auch das Substrat 105 bewegt werden. Im Allgemeinen wird die Bewegung des Substrats 105 der Bewegung des Retikel 102 entgegengesetzt sein, da ein einfaches Linsensystem ein Abbild erzeugt, welches auf dem Kopf steht. D.h. in Fig. 1 bewegt sich der Träger 104, auf welchem das Substrat 105 angeordnet ist, nach links, was durch einen zweiten Pfeil 108 angedeutet ist.

Bei der Bewegung des Retikel 102 und des Trägers 104 ist zu beachten, dass im Allgemeinen ein Linsensystem verwendet wird, welches die Strukturen, welche auf dem Retikel 102 angeordnet sind, nicht im Maßstab 1:1 auf das Substrat abbildet. In Fig. 1 ist schematisch durch das "4x" auf dem Linsensystem angedeutet, dass die Strukturen im Maßstab 4:1 auf das Substrat abgebildet werden. Hierbei müssen die Geschwindigkeiten der Bewegungen des Retikel 102 und des Trägers 104 an den Abbildungsmaßstab angepasst werden. Im Allgemeinen wird ein Linsensystem verwendet, welches die Strukturen verkleinert. Wird ein Linsensystem verwendet, welches die Strukturen z.B. um den Faktor vier verkleinert, so muss die Geschwindigkeit, mit welcher das Retikel bewegt wird, um den Faktor vier größer sein als die Geschwindigkeit, mit welcher der Träger 104 und damit das Substrat 105 bewegt wird.

In **Fig. 2** wird nun schematisch gezeigt wie ein Immersionsfluid zwischen das Linsensystem 103 und das Substrat 105 eingebracht werden kann.

Fig. 2 zeigt eine Seitenansicht eines Details aus der Anordnung für ein erfindungsgemäßes Immersions-Lithograpie-Verfahren.

In Fig. 2 ist das Linsensystem 103, der Träger 105 und das Substrat 105 dargestellt. Der Halter 101, das Retikel 102 und der Belichtungsschlitz 107 sind der Übersichtlichkeit wegen nicht in Fig. 2 dargestellt. Die Bewegung des Trägers 104 ist mit dem Doppelpfeil 209 dargestellt. Dieser soll andeuten, dass sich der Träger 104 in zwei Richtungen bewegen kann, je nachdem wie sich das nicht dargestellte Retikel 102 bewegt. Zusätzlich ist in Fig. 2 symbolisch eine Zuleitung 210 dargestellt, mittels welcher ein Immersionsfluid 211 zwischen das Linsensystem 103 und das Substrat 106 eingebracht werden kann. Im Ausführungsbeispiel ist das Immersionsfluid hochreines Wasser, d.h. Wasser, welches arm an Fremdstoffen wie zum Beispiel Sauerstoff oder Fremdstoffen, ist, oder ein Perfluorpolyether, wie zum Beispiel der unter den Handelsnamen Krytox® bekannte Perfluorpolyether.

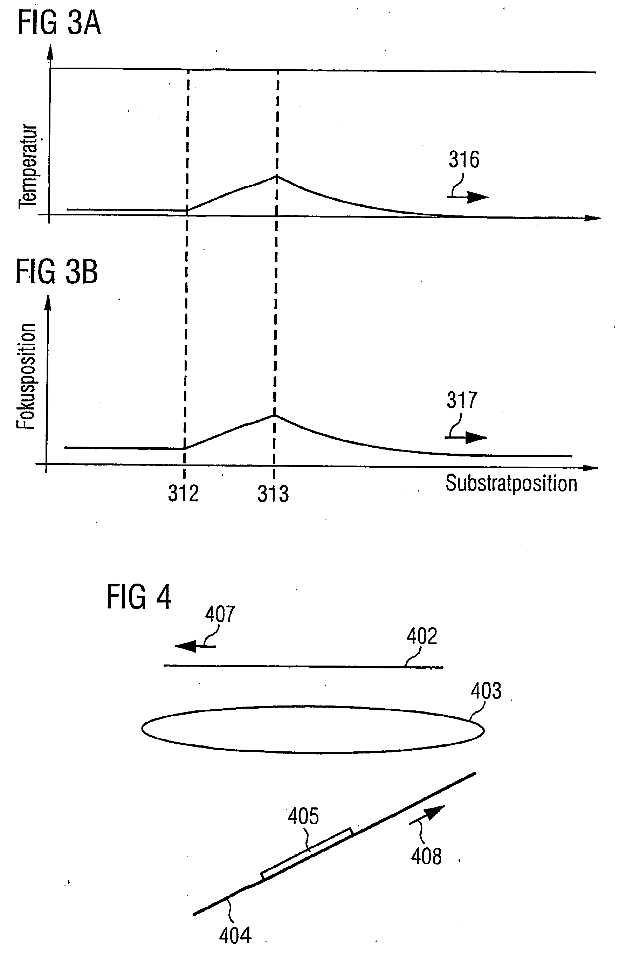

In **Fig. 3** wird schematisch der Verlauf der Temperatur des Immersionsfluid und der z-Position des Fokus, entlang der Position des Belichtungsschlitzes gezeigt.

In **Fig. 3a** stellt die Ordinate (Y-Achse) die Temperatur des Immersionsfluid in beliebigen Einheiten und die Abszisse (X-Achse) die x-Position auf dem Substrat dar. Fig. 3a stellt anschaulich eine Momentaufnahme der Temperatur über der Position auf dem Substrat dar. Zusätzlich ist mittels der gestrichelten Linien 312 und 313 der Bereich angegeben, in welchen hinein der Belichtungsschlitz abgebildet wird. Die beiden gestrichelten Linien 312 und 313 geben anschaulich die erste bzw. zweite Randbegrenzung des Belichtungsschlitzes wieder. In Fig. 3a bewegt sich das Substrat nach rechts, was durch den Pfeil 316 angedeutet ist. Die Bewegung des Substrats nach rechts hat zur Folge, dass sich die Temperatur des Immersionsfluid von dem Bereich des Substrats, welcher durch die Bewegung des Trägers gerade in den Bereich eindringt, in welchen der Belichtungsschlitz abgebildet wird (312), zu dem Bereich des Substrats, welcher gerade den Bereich verlässt, in welchen der Belichtungsschlitz abgebildet wird (313), kontinuierlich zunimmt. Diese kontinuierliche Zunahme der Temperatur hängt damit zusammen, dass das Immersionsfluid, welches in den Zwischenraum zwischen Linsensystem und Substrat eingeleitet wird, praktisch an der Substratoberfläche haftet und sich somit mit dem Substrat mitbewegt. Somit ist das Immersionsfluid, welches in der Fig. 3 an der gestrichelten Linie 313 den Bereich gerade verlässt, in welchen der Belichtungsschlitz abgebildet wird, am längsten der Belichtung ausgesetzt gewesen und somit am stärksten einer Temperaturerhöhung durch die teilweise Absorption des Laserstrahls unterworfen. Nachdem das Substrat den Bereich verlassen hat, in welchen der Belichtungsschlitz abgebildet wird, nimmt die Temperatur des Immersionsfluid wieder ab.

In **Fig. 3b** stellt die Ordinate (Y-Achse) die z-Position des besten Fokus und die Abszisse (X-Achse) die x-Position auf dem Substrat dar. Fig. 3b stellt anschaulich eine Momentaufnahme der z-Position der Ebene in der ein scharfes Abbild erzeugt wird über der Position auf dem Substrat dar. Zusätzlich geben die gestrichelten Linien 312 und 313 wiederum den Bereich an, in welchen hinein der Belichtungsschlitz abgebildet wird. In Fig. 3b bewegt sich das Substrat nach rechts, was durch den Pfeil 317 angedeutet ist. Dies ist analog zu der Fig. 3a zu sehen. Die Bewegung nach rechts des Substrats hat zur Folge, dass sich, wie in Fig. 3a gezeigt, die Temperatur, mit dieser der Brechungsindex und damit auch die in Fig. 3b dargestellte z-Position des besten Fokus in dem Bereich des Substrats, welcher durch die Bewegung des Trägers gerade in den Bereich eindringt, in welchen der Belichtungsschlitz abgebildet wird (312), zu dem Bereich des Substrats, welcher gerade den Bereich verlässt, in welchen hinein der Belichtungsschlitz abgebildet wird (313), kontinuierlich ändert. Die z-Position des besten Fokus rückt immer näher an das Linsensystem heran. Diese kontinuierliche Variation der z-Position hängt mit dem kontinuierlichen Anstieg der Temperatur des Immersionsfluid zusammen, da der Brechungsindex in erster Näherung proportional zur Temperatur ist und die z-Position wiederum in erster Näherung proportional zum Brechungsindex ist. Somit folgt der Verlauf der z-Position des besten Fokus, welche in Fig. 3b dargestellt ist, dem Verlauf der Temperatur, welche in Fig. 3a dargestellt ist.

In **Fig. 4** ist eine schematische Seitenansicht einer Scan-Belichtungsvorrichtung gemäß einem ersten Ausführungsbeispiel der Erfindung dargestellt. Die Scan-Belichtungsvorrichtung von Fig. 4 weist ein Retikel 402, ein abbildendes Element 403, welches in Fig. 4 schematisch als eine einzelne Linse dargestellt ist, und einen Träger 404 auf, auf welchem ein Substrat 405 angeordnet ist. Zwischen dem Substrat 405 und der Linse 403 wird während des Belichtens des Substrats ein Immersionsfluid eingeleitet, welches der Übersichtlichkeit wegen in Fig. 4 nicht dargestellt ist.

Im ersten Ausführungsbeispiel wird der Abstand zwischen dem Retikel 402 und der zu belichtenden Oberfläche des Substrats 405 in der Bewegungsrichtung, oder anders ausgedrückt während der Bewegung, variiert, indem der Träger 404 schräg im Bezug zu dem Retikel 402 bewegt wird. Die Bewegungsrichtung des Retikel 402 ist mit einem ersten Pfeil 407 angedeutet und ist in Fig. 4 nach links, während die Bewegungsrichtung des Halters 404 und damit des Substrats 405, welche in Fig. 4 nach rechts verläuft, mit einem zweiten Pfeil 408 angedeutet ist. Zur Verdeutlichung der Erfindung wurde die Schräge der Bewegung des Trägers 404 gegenüber der Ausrichtung des Retikel 402, d.h. der Relativwinkel den das Retikel 402 und der Träger 404 bilden, in Fig. 4 stark überhöht dargestellt. In einem korrekten Maßstab wäre der Relativwinkel, welcher einzustellen wäre, um die durch die Erwärmung des Immersionsfluid erzeugte Fokuspositionsänderung zu kompensieren, nicht in der Figur erkennbar.

Nachfolgend wird kurz erläutert, wie die Größe der Variation des Abstandes zwischen dem Retikel und dem Substrat bestimmt werden kann.

In einer herkömmlichen Lithographie-Belichtungs-Vorrichtung, auch "Exposure Tool" genannt, wird vor der eigentlichen Belichtung an jedem Feld des Substrats, einem so genannten Belichtungsfeld, welches nach einer erfolgten Prozessierung einzelne elektronische Bauteile enthält, eine Kalibration durchgeführt. Diese ist im Allgemeinen notwenig, da zu einer korrekten Belichtung, d.h. einer Belichtung mit kleiner Auflösung, das einzelne Substrat, zum Beispiel in seinem Höhenprofil, genau zu vermessen ist. Aus der Kalibrierungsmessung ergibt sich dann unter anderem ein Höhenprofil eines einzelnen Belichtungsfelds innerhalb des Substrats. Zu diesem Höhenprofil kann dann einfach noch ein Offset, welcher sich durch die z-Positionsverschiebung des besten Fokus, welche aus der Temperaturänderung des Immersionsfluid folgt, hinzugerechnet werden. Der Wert des Offsets steigt, wie in Fig. 3b dargestellt, in erster Näherung, in dem Bereich des Belichtungsfeldes, welcher gerade aktuell durch den Belichtungsschlitz hindurch belichtet wird, linear an. Der Offset, welcher sich durch die Temperaturänderung des Immersionsfluid ergibt, kann korrespondierend mit der Kalibrationsmessung bestimmt und gespeichert werden. Vorzugsweise werden zwei Kalibrationen durchgeführt, wobei in einer ersten Kalibration jedes Belichtungsfeld vor der Belichtung vermessen wird und in einer zweiten Kalibration für eine gegebene Installation einmal der Offset gemessen wird. Der Offset kann dann je nach Bedarf, d.h. nach den Gegebenheiten am Anfang der Belichtung jedes Substrats oder Wafers, oder stündlich, täglich oder sonstigen gegebenen Zeitabständen korrigiert werden. Nachdem der Offset gespeichert ist, z.B. in Form einer Tabelle einem so genannten "Lookup Table", kann er dann bei einer nachfolgenden Belichtung des Belichtungsfeldes berücksichtigt werden, indem er dem Höhenprofil des Belichtungsfeldes hinzuaddiert wird. Die Speicherung kann zum Beispiel in einem Speicher eines Computers erfolgen, welcher Computer auch bei der Durchführung und Auswertung der Kalibrationsmessung und/oder bei der Bestimmung des Offsets verwendet werden kann. Die Speicherung bietet den Vorteil, dass die gleichen Offsets mehrfach verwendet werden können, wenn gleiche Belichtungen, d.h. ein Belichtungsprozess mit gleichen Parametern, wie zum Beispiel Belichtungszeit, Photolack, Retikel usw., durchgeführt werden. Dies erspart eine neue Berechnungen und/oder neue Messungen der Offsets.

Um den Offset zu bestimmen, ist der Temperaturanstieg $\delta T$ des Immersionsfluid entlang der Bewegung des Trägers zu bestimmen. Aus diesem Temperaturanstieg $\delta T$ des Immersionsfluid entlang der Bewegungsrichtung lässt sich bei bekannten dn/dT die Änderung des Brechungsindex $\delta n$ berechnen. In erster Näherung kann hierzu dn/dT als Materialkonstante des Immersionsfluid angenommen werden. $\delta T$ kann mittels der Gleichung (3):

$$\delta T = (1 - \tau)\gamma / cD$$

bestimmt werden.
Wobei:

$\delta T$ der Temperaturanstieg,

$\tau$ der Transmissionskoeffizient des Immersionsfluid, $\gamma$ die Energiedosis, welche benötigt wird, um den bei der Belichtung verwendeten Photolack zu belichten, c die spezifische Wärme des Immersionsfluid, und D der Abstand zwischen abbildenden Element und Substrat ist, d.h. der Arbeitsabstand.

Somit ergibt sich für die Defokussierung, d.h. die Verschiebung der z-Position des besten Fokus, durch die Temperaturänderung des Immersionsfluid in erster Näherung die schon oben angegebene Gleichung (2)

$$\Delta D = \frac{D \cdot \delta n}{n \cdot \cos^2 \theta} \quad .$$

Hieraus kann nun die benötigte Variation des Abstandes entlang des gesamten Bereiches auf dem Substrat berechnet werden, auf welchen der Belichtungsschlitz abgebildet wird, d.h. den Bereich in den Fig. 3a und 3b zwischen den Linien 312 und 313. Für die lineare Näherung der Geschwindigkeit der Variation der z-Position des besten Fokus, auch "best focus" genannt, d.h. der nötigen Geschwindigkeit des Substrats in Richtung der z-Koordinate, ergibt sich aus Gleichung (2), Gleichung (3) und $\delta n = \frac{dn}{dT} \cdot \delta T$ die folgende Gleichung (4):

$$\frac{\Delta D}{\Delta t} = \frac{\frac{dn}{dT} \cdot (1 - \tau) \cdot \gamma}{c \cdot n \cdot \cos^2 \theta} \cdot \frac{1}{\Delta t} \quad .$$

wobei $\Delta t$ die Zeit ist, welche ein Punkt auf dem Substrat belichtet wird, d.h. die Zeit, welcher ein Punkt benötigt, um nachdem er in den Bereich des Belichtungsschlitzes eingedrungen ist, diesen Bereich wieder zu verlassen, anders ausgedrückt die Zeit, welche ein Punkt auf den Substrat benötigt, um in Fig. 3a bzw. 3b den Weg von der gestrichelten Linie 312 bis zur gestrichelten Linie 313 zurückzulegen.

Aus (4) lässt sich wie oben erläutert eine Geschwindigkeit in z-Richtung berechnen, welche die zu belichtende Oberfläche des Substrats aufweist, um die Änderung des Brechungsindex des Immersionsfluid durch die Temperatursteigerung des Immersionsfluid bei der Belichtung zu kompensieren. Die Richtung der Geschwindigkeit in z-Richtung hängt hierbei von dem Vorzeichen von dn/dT ab, im Allgemeinen ist dieses so, dass der Abstand zwischen der zu belichtenden Oberfläche des Substrats und abbildenden Element entlang der Bewegungsrichtung abnimmt, um die durch die Temperaturänderungen verursachten Änderungen zu kompensieren, so wie es sich auch aus Fig. 3b ergibt.

Die Geschwindigkeit in z-Richtung kann auch in einfacher Weise in einen Relativwinkel umgerechnet werden, welche die zu belichtende Oberfläche des Substrats im Bezug auf das Retikel aufweisen muss.

Neben der oben beschriebenen Berechnung der Verschiebung des best focus in z-Richtung kann die Verschiebung des best focus auch experimentell bestimmt werden. Die experimentelle Bestimmung ist unter Umständen einfacher als das beschriebene analytische Verfahren durchzuführen. Zum Beispiel müssen hierbei nicht unbedingt die für die Berechnung benötigten Parameter bekannt sein. Es wird einfach die z-Position Verschiebung des best focus für eine gegebene Belichtungsvorrichtung gemessen.

In **Fig. 5** ist eine schematische Seitenansicht einer Scan-Belichtungsvorrichtung gemäß einem zweiten Ausführungsbeispiel der Erfindung dargestellt. Die Scan-Belichtungsvorrichtung von Fig. 5 weist ein Retikel 502, ein abbildendes Element 503, welches in Fig. 5 schematisch als eine einzelne Linse dargestellt ist, und einen Träger 504 auf, auf welchem ein Substrat 505 angeordnet ist. Ein zwischen dem Substrat 505 und der Linse 503 eingebrachtes Immersionsfluid ist der Übersichtlichkeit wegen in Fig. 5 nicht dargestellt.

Dargestellt sind hingegen noch zwei Ebenen, welche die Funktionsweise des zweiten Ausführungsbeispiels erläutern helfen sollen. Im zweiten Ausführungsbeispiel wird nicht der Träger 504 mit dem Substrat 505 schräg bewegt, sondern das Retikel 502 wird schräg bewegt. Auch hierdurch ist es möglich die durch die Temperaturerhöhung und die damit korrelierte Brechungsindexänderung verursachte Verschiebung der z-Position des schärfsten Abbildes zu kompensieren. Zu beachten ist hierbei, dass üblicherweise ein abbildendes Element verwendet wird, welches eine Verkleinerung bewirkt. In Fig. 5 ist dies symbolisch mit dem "4x", welches in der symbolischen Linse 403 geschrieben ist, verdeutlicht. Eine Verkleinerung im Maßstab 4:1 wirkt sich im Abstand des besten Fokus und damit in der z-Richtung mit einen Faktor 16 aus, d.h. den Verkleinerungsfaktor zum Quadrat $(4:1)^2$. Hierdurch muss das Retikel 502 bei der Bewegung wesentlich stärker verkippt werden, als das Substrat 405 im, in Fig. 4 dargestellten, ersten Ausführungsbeispiel. Die sich aus Gleichung (4) ergebende Geschwindigkeit in z-Richtung oder der sich ergebene Relativwinkel muss um diesen Faktor 16 vergrößert werden.

Um diesen Sachverhalt darzustellen, sind in Fig. 5 wie bereits gesagt noch zwei Ebenen eingezeichnet. Die erste Ebene 514 zeigt die "Verkippung", welche das durch die Linse 503 erzeugte Abbild des Retikel 502 aufweist. Diese erste Ebene 514 besitzt aus oben genannten Grund, eine schwächere Verkippung, als das Retikel 502 selber. Die erste Ebene 514 gibt die Lage, oder die Verkippung an, welche die zu belichtende Oberfläche des Substrats 505 in einer Lithographie-Vorrichtung haben müsste, welche keine Effekte der Brechungsindexveränderung durch eine Bestrahlung eines Mediums zwischen der Linse 503 und dem Substrat 505 aufweisen würde. Da erfindungsgemäß jedoch eine Immersions-Lithograpie-Vorrichtung verwendet wird, bei welcher zwischen Linse 503 und Substrat 505 ein Immersionsfluid eingebracht ist, kommt durch die Veränderung des Brechungsindex mit der Temperatur eine Verkippung des Bildes, oder anders ausgedrückt eine Variation der z-Position (des Abstandes) des besten Fokus, zustande. Diese Verkippung ist mit einer zweiten Ebene 515 in Fig. 5 dargestellt. Die zweite Ebene gibt die Variation des besten Fokus durch die Temperaturänderung an. Um die Ebene des besten Fokus nach den Auswirkungen der Brechungsindexänderung durch die Temperaturänderung in dem Immersionsfluid und der Verkippung des Retikel zu erhalten, wird die Verkippung der ersten Ebene 514 und der zweiten Ebene 515 "zusammenaddiert". Daraus ergibt sich die resultierende Abbildungsebene, auf welcher das Abbild des Retikel am schärfsten abgebildet wird. In Fig. 5 sind die Neigungen der ersten Ebene 514 und der zweiten Ebene 515 gleich groß aber mit entgegengesetzten Vorzeichen dargestellt, so dass die resultierende Abbildungsebene in Fig. 5 horizontal ist.

Somit ergibt sich im zweiten Ausführungsbeispiel, welches in Fig. 5 dargestellt ist, ein scharfes Abbild des Retikel 502 auf der zu belichtenden Oberfläche des Substrats 505, wenn die zu belichtende Oberfläche des Substrats 505 in Fig. 5 in horizontaler Richtung unterhalb des Linsensystems 503 bewegt wird.

Zusammenfassend kann die Erfindung darin gesehen werden, dass bei einer Immersions-Lithographie-Technik, welche mittels einer Scan-Belichtungsvorrichtung durchgeführt wird, die Variationen der Position des besten Fokus, d.h. der schärfsten Abbildung, welche durch die Änderung des Brechungsindex des Immersionsmediums mit der Änderung der Temperatur des Immersionsmediums durch Absorption im Immersionsmedium, nicht wie im Stande der Technik durch alleine Regelung der Temperatur des Immersionsmediums verhindert werden, sondern dass eine Kompensation dieser Fokusvariationen durchgeführt wird, indem ein Abstand zwischen Retikel und zu belichtender Oberfläche eines Substrat entlang der Bewegungsrichtung des Substrats variiert wird. Die Änderung des Abstandes entspricht einem Offset, welcher der normaler Bewegung des Substrats und/oder Retikel, d.h. der Bewegung wie sie ein Substrat und/oder Retikel in einer Immersions-Lithographie-Vorrichtung gemäß dem Stand der Technik ausführen, hinzugerechnet wird. Der Wert dieses Offsets lässt sich mittels der oben angegeben Gleichung (4) berechnen. Dieser Offset kann als eine lineare Bewegung in z-Richtung, d.h. der Richtung einer optischen Achse der Scan-Belichtungsvorrichtung verstanden werden. Die optische Achse entspricht in der Scan-Belichtungsvorrichtung der Achse entlang derer sich ein Strahl, z.B. einem Laserstrahl, welcher zum Belichten verwendet wird, ausbreitet.

In der Anmeldung sind folgende Dokumente zitiert:

[1] US 6 191 429
[2] US 6 586 160
[3] JP 10 303 114
[4] US 6 509 952

**Bezugszeichenliste**

| | |
|---|---|
| 100 | Scan-Belichtungsvorrichtung |
| 101 | Halter |
| 102 | Retikel |
| 103 | abbildendes Element |
| 104 | Träger |
| 105 | Substrat |
| 106 | Belichtungsschlitz |
| 107 | erster Pfeil (Bewegungsrichtung) |
| 108 | zweiter Pfeil (Bewegungsrichtung) |
| 209 | Doppelpfeil (Bewegungsrichtungen) |
| 210 | Zuleitung |
| 211 | Immersionsfluid |
| 312 | erste Randbegrenzung des Belichtungsschlitzes |
| 313 | zweite Randbegrenzung des Belichtungsschlitzes |
| 316 | Pfeil (Bewegungsrichtung) |
| 317 | Pfeil (Bewegungsrichtung) |
| 402 | Retikel |
| 403 | abbildendes Element |
| 404 | Träger |
| 405 | Substrat |
| 407 | erster Pfeil (Bewegungsrichtung) |
| 408 | zweiter Pfeil (Bewegungsrichtung) |
| 502 | Retikel |
| 503 | abbildendes Element |
| 504 | Träger |
| 505 | Substrat |
| 507 | erster Pfeil (Bewegungsrichtung) |
| 508 | zweiter Pfeil (Bewegungsrichtung) |
| 514 | erste Ebene |
| 515 | zweite Ebene |
| 600 | Lithographievorrichtung |
| 601 | Wafer |
| 602 | Laser |
| 603 | Linse |
| 604 | Maske |
| 605 | Laserstrahl |

**Patentansprüche**

1. Immersions-Lithographie-Verfahren zum Belichten eines Substrats (105; 405; 505), welches Verfahren mit einer Scan Belichtungsvorrichtung (100) durchgeführt wird, welche aufweist:

    eine Strahlquelle, welche einen Strahl erzeugt, einen Halter (101), welcher ein Retikel (102; 402; 502) aufnimmt,

    einen Träger (104; 404; 504), auf welchem ein Substrat angeordnet ist,
    ein abbildendes Element (103; 403; 503), welches zwischen dem Retikel und dem Substrat angeordnet ist, und
    bei dem beim Belichten des Substrats ein Immersionsfluid (211) zwischen das abbildende Element und das Substrat eingebracht ist,
    bei dem der Strahl von der Strahlungsquelle durch das Retikel, durch das abbildende Element und durch das
    Immersionsfluid hindurch auf eine zu belichtende Oberfläche des Substrats läuft,
    bei dem der Strahl das Retikel in einer ersten Richtung abscannt,

    **dadurch gekennzeichnet, dass** der Träger beim Belichten der zu belichtenden Oberfläche des Substrats in eine zweite Richtung (108; 408; 508) bewegt wird, bei dem die Schärfentiefe und/oder die Auflösung des Belichtens des Substrats eingestellt wird, indem beim Belichten mit dem Retikel ein Abstand in Strahlrichtung zwischen dem Retikel und der zu belichtenden Oberfläche des Substrats entlang der Bewegungsrichtung des Trägers linear kontinuierlich variiert wird, wobei die lineare kontinuierliche Variation des Abstandes derart erfolgt, dass die während des Belichtens durch eine kontinuierlich entlang der zweiten Richtung ansteigende Temperaturänderung des Immersionsfluid während des Belichtens verursachte Schärfentiefe- und/oder Auflösungsänderung kompensiert wird.

2. Verfahren gemäß Anspruch 1, bei dem das Immersionsfluid (211) ein Fluid mit einer hohen Transparenz bei einer gegebenen Belichtungswellenlänge und/oder mit einem kleinen dn/dT ist.

3. Verfahren gemäß Anspruch 1 oder 2, bei dem das Immersionsfluid (211) Wasser oder ein Perfluorpolyether ist.

4. Verfahren gemäß einem der Ansprüche 1 bis 3, bei dem der Träger (104; 404; 504) in Bezug auf das Retikel schräg bewegt wird.

5. Verfahren gemäß einem der Ansprüche 1 bis 4, bei dem das Retikel gegenüber der zu belichtenden Oberfläche des Substrats schräg bewegt wird.

6. Verfahren gemäß einem der Ansprüche 1 bis 5, bei dem die zweite Richtung (108; 408; 508) der ersten Richtung entgegengesetzt ist.

7. Verfahren gemäß einem der Ansprüche 1 bis 6, bei dem die Temperatur des Immersionsfluid (211) geregelt wird.

**8.** Verfahren gemäß einem der Ansprüche 1 bis 7, bei dem das abbildende Element (103; 403; 503) eine Linse oder eine Linsensystem ist.

**9.** Verfahren gemäß einem der Ansprüche 1 bis 8, bei dem das Immersionsfluid (211) während des Belichtens zwischen das abbildende Element (103; 403; 503) und das Substrat (105; 405; 505) eingebracht wird.

**10.** Verfahren gemäß einem der Ansprüche 1 bis 9, bei dem vor der Belichtung des Substrats (105; 405; 505) in einem Kalibrierungsschritt für das Substrat die Abstandsvariationen als Offsets bestimmt werden und bei der Belichtung des Substrats die Offsets verwendet werden, um die Abstandsvariationen durchzuführen.

**11.** Vorrichtung (100) zum Durchführen einer Immersions-Lithiographie zum Belichten eines Substrats (105; 405; 505), mit
einer Strahlquelle zum Emittieren eines Strahls;
einem Träger (104; 404; 504), auf welchem ein Substrat anordenbar ist;
einem Halter (101) zum Aufnehmen eines Retikels (102);
einem abbildenden Element (103), welches zwischen dem Halter und dem Träger angeordnet ist;
wobei der Träger und der Halter derart eingerichtet sind, dass sie gegeneinander bewegbar sind;
wobei die Vorrichtung derart eingerichtet ist, dass ein Immersionsfluid (211) zwischen das abbildende Element und den Träger einbringbar ist;
**dadurch gekennzeichnet, dass** die Vorrichtung derart eingerichtet ist, dass ein im Halter angeordnetes Retikel und eine zu belichtende Oberfläche eines auf dem Träger angeordneten Substrats beim Belichten der Oberfläche des Substrats gegeneinander derart verkippt sind, dass eine lineare kontinuierliche Variation des Abstandes zwischen dem Retikel und der zu belichtenden Oberfläche des Substrats entlang der Bewegungsrichtung (108; 408; 508) des Trägers während des Belichtens ausgeführt wird; und
dass die Vorrichtung derart eingerichtet ist, dass das Verkippen während des Belichtens der Oberfläche eine durch eine entlang der Bewegungsrichtung des Trägers kontinuierlich ansteigende Temperaturänderung des Immersionsfluid während des Belichtens verursachte Schärfentiefe- und/oder Auflösungsänderung kompensiert.

**Claims**

**1.** An immersion lithography method for the exposure of a substrate (105; 405; 505),
wherein the method is carried out by means of a scanning exposure device (100), the scanning exposure device (100) comprising:

> a beam source, which generates a beam,
> a holder (101), which accommodates a reticle (102; 402; 502),
> a carrier (104; 404; 504), on which a substrate is arranged,
> an imaging element (103; 403; 503), which is arranged between the reticle and the substrate, and

wherein an immersion fluid (211) is introduced between the imaging element and the substrate during the exposure of the substrate,
wherein the beam passes from the beam source through the reticle, the imaging element, and the immersion fluid onto a substrate surface to be exposed,
wherein the beam scans the reticle along a first direction,
**characterized in that**,
the carrier is moved in a second direction (108; 408; 508) during the exposure of the substrate surface to be exposed,
wherein the depth of focus and/or the resolution of the exposure of the substrate is set by linearly continuously varying a distance in the beam direction between the reticle and the substrate surface to be exposed along the movement direction of the carrier during the exposure with the reticle, wherein the linear continuous variation of the distance is performed such that the depth of focus change and/or image resolution change during the exposure caused by the continuously increasing change in temperature of the immersion fluid along the second direction during the exposure is compensated.

**2.** The method according to claim 1,
wherein the immersion fluid (211) is a fluid having a high transparency at a given exposure wavelength and/or having a small dn/dT.

**3.** The method according to claim 1 or 2,
wherein the immersion fluid (211) is water or a perfluoropolyether.

**4.** The method according to one of the claims 1 to 3,
wherein the carrier (104; 404; 504) is moved obliquely with respect to the reticle.

**5.** The method according to one of the claims 1 to 4,
wherein the reticle is moved obliquely with respect to the substrate surface to be exposed.

**6.** The method according to one of the claims 1 to 5,
wherein the second direction (108; 408; 508) is opposite to the first direction.

**7.** The method according to one of the claims 1 to 6, wherein the temperature of the immersion fluid (211) is regulated.

**8.** The method according to one of the claims 1 to 7, wherein the imaging element (103; 403; 503) is a lens or a lens system.

**9.** The method according to one of the claims 1 to 8, wherein the immersion fluid (211) is introduced between the imaging element (103; 403; 503) and the substrate (105; 405; 505) during the exposure.

**10.** The method according to one of the claims 1 to 9, wherein, prior to the exposure of the substrate (105; 405; 505), the distance variations are determined as offsets in a calibration step for the substrate, and wherein during the exposure of the substrate the offsets are used to carry out the distance variations.

**11.** A device (100) for carrying out an immersion lithography for the exposure of a substrate (105; 405; 505), with

a beam source for emitting a beam;

a carrier (104; 404; 504) configured to accommodate a substrate;

a holder (101) for accommodating a reticle (102); and an imaging element (103), which is arranged between the holder and the carrier, wherein the carrier and the holder are arranged such that they are moveable in relation to one another;

wherein the device is configured such that an immersion fluid (211) can be introduced between the imaging element and the carrier;

**characterized in,**

**that** the device is configured such that, a reticle being arranged in the holder and a surface to be exposed of a substrate being arranged on the carrier are tilted in relation to one another during the exposure of the surface of the substrate, such that a linear continuous variation of the distance between the reticle and the substrate surface to be exposed along the movement direction (108; 408; 508) of the carrier is carried out during the exposure; and

**that** the device is configured such that the tilting during the exposure of the surface compensates a depth of focus and/or image resolution change during the exposure caused by a linearly continuously increasing temperature change of the immersion fluid along the movement direction of the carrier.

**Revendications**

**1.** Procédé de lithographie par immersion pour exposer un substrat (105 ; 405 ; 505), lequel procédé est effectué avec un dispositif (100) d'exposition par balayage, qui a :

une source de rayonnement pour l'émission d'un faisceau ;

un porte réticule (101) qui reçoit un réticule (102 ; 402 ; 502),

un support (104 ; 404 ; 504) sur lequel est disposé un substrat,

un élément (103 ; 403 ; 503) à reproduire qui est disposé entre le réticule et le substrat, et

dans lequel, lors de l'exposition du substrat, a un fluide (211) d'immersion est mis entre l'élément à reproduire et le substrat,

dans lequel le faisceau de la source de rayonnement arrive sur une surface à exposer du substrat, en passant à travers le réticule, l'élément à reproduire et le fluide d'immersion,

dans lequel le faisceau balaye le réticule dans une première direction,

**caractérisé en ce que**, lors de l'exposition de la surface à exposer du substrat, on déplace le support dans une deuxième direction (108 ; 408 ; 508), dans lequel on règle la profondeur de champ et/ou la résolution de l'exposition du substrat en modifiant continuellement d'une manière linéaire dans la direction de déplacement du support, lors de l'exposition par le réticule, une distance dans la direction du faisceau entre le réticule et la surface à exposer du substrat, la modification continue linéaire de la distance s'effectuant de manière à compenser, pendant l'exposition, la variation de profondeur de champ et/ou de résolution provoquée, pendant l'exposition, par une variation de la température du fluide d'immersion croissante continuellement dans la deuxième direction.

**2.** Procédé suivant la revendication 1, dans lequel le fluide (211) d'immersion est un fluide ayant une grande transparence pour une longueur d'onde d'exposition donnée et/ou un dn/dT petit.

**3.** Procédé suivant les revendications 1 ou 2, dans lequel le fluide (211) d'immersion est l'eau ou un perfluoropolyéther.

**4.** Procédé suivant l'une des revendications 1 à 3, dans lequel on déplace le support (104 ; 404 ; 504) de manière inclinée par rapport au réticule.

**5.** Procédé suivant l'une des revendications 1 à 4, dans lequel on déplace le réticule de manière inclinée par rapport à la surface à exposer du substrat.

**6.** Procédé suivant l'une des revendications 1 à 5, dans lequel la deuxième direction (108 ; 408 ; 508) est de sens contraire à la première direction.

**7.** Procédé suivant l'une des revendications 1 à 6, dans lequel on régule la température du fluide (211) d'immersion.

8. Procédé suivant l'une des revendications 1 à 7, dans lequel l'élément (103 ; 403 ; 503) à reproduire est une lentille ou un système de lentilles.

9. Procédé suivant l'une des revendications 1 à 8, dans lequel on met pendant l'exposition le fluide (211) d'immersion entre l'élément (103 ; 403; 503) à reproduire et le substrat (105 ; 405; 505).

10. Procédé suivant l'une des revendications 1 à 9, dans lequel avant l'exposition du substrat (105 ; 405; 505), on détermine dans un stade d'étalonnage pour le substrat des variations de distance en tant que décalages et dans lequel on utilise les décalages lors d'exposition du substrat pour effectuer les modifications de distance.

11. Dispositif (100) pour effectuer une lithographie par immersion pour l'exposition d'un substrat (105 ; 405 ; 505) comprenant
une source de rayonnement pour l'émission d'un faisceau ;
un support (104; 404 ; 504) sur lequel peut être disposé un substrat ;
un porte-réticule (101) de réception d'un réticule (102) ; un élément (103) à reproduire qui est disposé entre le porte-réticule et le support ;
dans lequel le support et le porte-réticule sont agencés de manière à pouvoir être déplacés l'un par rapport à l'autre ;
dans lequel le dispositif est agencé de manière à pouvoir mettre un fluide (211) d'immersion entre l'élément à reproduire et le support ;
**caractérisé en ce que** le dispositif est agencé de manière à ce qu'un réticule monté dans le porte réticule et une surface à exposer d'un substrat disposé sur le support soient, lors de l'exposition de la surface du substrat, basculés l'un par rapport à l'autre de façon à réaliser pendant l'exposition une modification continue linéaire de la distance entre le réticule et la surface à exposer du substrat dans la direction (108; 408 ; 508) de déplacement du support, et
**en ce que** le dispositif est agencé de manière à ce que le basculement compense une variation de profondeur de champ et/ou de résolution provoqué pendant l'exposition par une variation de la température du fluide d'immersion croissante d'une manière continue dans la direction de déplacement du support.

FIG 1

FIG 2

## FIG 3A

Temperatur

316

## FIG 3B

Fokusposition

317

312    313    Substratposition

## FIG 4

407

402

403

405

404

408

## FIG 5

507

502

503

4x

514

515

504

505

508

## FIG 6

600

602

605

604

603

601

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5094536 A
- WO 2004107417 A
- WO 9949504 A
- US 6191429 B
- US 6586160 B
- JP 10303114 B
- US 6509952 B